# EUROPEAN PATENT SPECIFICATION

(11) **EP 0 643 400 B1**
(45) Date of publication and mention of the grant of the patent: **21.01.1998**
(21) Application number: 94116681.1
(22) Date of filing: 02.06.1992
(51) Int. Cl.: H01B 12/00, H01L 39/24, H01L 39/12

(54) **Method for making a superconductor thin film**
Herstellungsverfahren für Dünnschicht-Supraleiter
Procédé de fabrication d'supraconducteur à couche mince

(30) Priority: 04.06.1991 JP 132736/91; 26.12.1991 JP 344519/91; 26.12.1991 JP 344520/91
(43) Date of publication of application: 15.03.1995
(62) Divisional of application: 92109241.7
(73) Proprietor: MATSUSHITA ELECTRIC INDUSTRIAL CO., LTD., Kadoma-shi Osaka (JP)
(72) Inventor: Ichikawa, Yo, Moriguchi-shi, Osaka 570 (JP); Setsune, Kentaro, Sakai-shi, Osaka 590-01 (JP); Adachi, Hideaki, Neyagawa-shi, Osaka 572 (JP)
(74) Representative: Eisenführ, Speiser & Partner

(56) References cited:
- EP-A- 0 329 929
- EP-A- 0 357 500
- EP-A- 0 366 949
- JAPANESE JOURNAL OF APPLIED PHYSICS, vol. 27, . no. 5, 1988, May MASAO NAKAO et al."Sputtered T1-Ca-Ba-Cu-O Thin Films with Zero Resistivity at 98 K" pages L849-L851

## Description

The present invention relates to a method of manufacturing an oxide superconductor thin film of high quality stably.

Niobium nitride (NbN) and niobium germanium (Nb₃Ge) of A15 type binary compound were known as high temperature superconductors. However, the superconducting transition temperatures of these materials are 23 K at most. On the other hand, perovskite structure compounds were expected to have higher transition temperatures and high temperature superconductors of Ba-La-Cu-O system were suggested (J. Bednorz and K. A. Muller, Zeitschrift für Physik B-Condensed Matter 64, 189-193 (1986)). Further, Bi-Sr-Ca-Cu-O and Tl-Ba-Ca-Cu-O materials were found to have transition temperatures of 100 K or more (H. Maeda, Y. Tanaka, M. Fukutomi and T. Asano, Japanese Journal of Applied Physics 27, L209-L210 (1988), and Z. Z. Sheng and A. M. Herman, Nature 332, 55-58 (1988)). The details of the mechanism of the superconductivity of these kinds of oxide materials are not yet clear. However, there is a possibility that they have a transition temperature higher than room temperature, and applications in electronic device area are expected with use of these materials more than with use of the prior binary compounds.

In order to use an oxide high temperature superconductor such as Bi-Sr-Ca-Cu-O or Tl-Ba-Ca-Cu-O practically, it is demanded to manufacture it in a form of thin film. However, it is difficult previously to prepare a thin film having good superconducting characteristics. It is known that Bi-Sr-Ca-Cu-O system has phases having different superconducting transition temperatures, and it was very difficult to prepare the phase itself of 100 K or more of superconducting transition temperature in a form of thin film.

Further, an insulator or a dielectric film of thickness of a few tens nanometers is needed in order to manufacture a periodic layered structure of superconductors and insulators layered alternately and an integrated device with use of such a layered structure. Especially, it is very difficult to manufacture a periodically layered structure of high temperature oxide superconductor films and insulator films. In order to prepare a thin film having good superconducting characteristics, it was necessary to conduct heat treatment or heating process on preparation. However, this causes mutual diffusion of atoms between the insulator and superconductor films so as to deteriorate the characteristics of the constituent layers. When an insulator film of for example Bi-W-O system is prepared by using a prior art technique, though tungsten becomes a stable oxide at high temperatures, it is a problem that bismuth is hard to become a stable oxide and becomes an unstable crystal. This makes it almost impossible to construct an integrated device such as a Josephson device which uses this structure.

Along with the development of such oxide superconductors, an insulator and its thin film which are stable in a heating process on manufacturing an oxide superconductor are developed (Ichikawa et al. Japanese Journal of Applied Physics 27, L381-L383 (1988)).

Recently, the inventors developed a layered structure of Bi-Sr-Ca-Cu-O superconductors and Bi-Ti-O or Bi-W-O insulators layered alternately (Japanese Patent laid open Publications Nos. 298257/1990 and 82749/1991). However, these layered structures have the above-mentioned problems caused by the heating.

The European patent EP-A-0 329 929 describes that an atmosphere with high content of ozone and/or mono-atomic oxygen together with traditional bi-atomic oxygen is applied to all systems for a process of manufacturing a Y oxide superconductor.

The European patent application EP-A-0 336 949 discloses a Josephson device and its manufacturing method. In a Josephson junction shown in Fig. 1 of this document the oxide layer 3 is interposed between two oxide superconductors 2 and 4 of Bi-Sr-Ca-Cu-0. The oxide layer 3 may be made of Bi-W-O.

The European patent application EP-A-0 357 500 discloses a manufacturing method of Bi-superconductors. According to this document the substrate shall be heated at a temperature between 670 and 750°C during the deposition.

An object of the present invention is to provide a manufacturing method of an oxide insulator film.

A second object of the present invention is to provide a manufacturing method of a layered structure including oxide superconductors and oxide insulators layered alternately.

In order to attain the above-mentioned objects, according to the present invention a manufacturing method of an oxide thin film comprises the steps of: providing a substrate, heating the substrate, supplying an environment including activated oxygen gas around the substrate, depositing an oxide superconductor layer including at least thallium, copper and an alkaline earth element in the 11a group in the periodic table, and depositing an oxide insulator including at least bismuth, tungsten and oxygen as main components on the superconductor oxide layer, wherein the successive deposition of an oxide superconductor layer and oxide insulator layer is repeated at least once.

A thin film including at least bithmuth (Bi), titanium (Ti) and oxygen (O) as main components is formed in an environment including activated oxygen gas. A dielectric thin film including at least bithmuth (Bi), tungsten (W) and oxygen (O) as main components is also formed in an environment including activated oxygen gas.

A layered structure of superconductors and insulators is manufactured by layering an oxide superconductor film (Bi-Sr-Ca-Cu-O, Tl-Ba-Ca-Cu-O or the like) and an oxide insulator thin film (Bi-Ti-O, Bi-W-O or the like) alternately on a substrate in an environment including activated oxygen gas.

An advantage of the present invention is that an oxide insulator layer of thin thickness can be prepared stably.

Another advantage of the present invention is that a layered structure of oxide superconductor thin films and oxide insulator thin films layered alternately is manufactured stably.

A third advantage of the present invention is that a layered structure of Tl-Ba-Ca-Cu-O superconductor thin films and Bi-W-O insulator thin films layered alternately.

### BRIEF DESCRIPTION OF THE DRAWINGS

These and other objects and features of the present invention will become clear from the following description taken in conjunction with the preferred embodiments thereof with reference to the accompanying drawings, and in which:

Fig. 1 is a schematic diagram of a manufacturing apparatus of thin film in Embodiment 1 of the present invention.

Fig. 2 is a graph of a change of the amount of Bi adhered to a substrate of the same embodiment.

Fig. 3 is a diagram of X-ray spectra of Bi-Ti-O thin film prepared with the apparatus of Fig. 1.

Fig. 4 is a schematic diagram of structure in a Embodiment 2 of the present invention,

Fig. 5 is a schematic diagram of a manufacturing apparatus of thin film in Embodiment 2 of the present invention.

Fig. 6 is a graph of the temperature characteristic of resistance of a thin film manufactured by using only argon and oxygen gas in the apparatus of Fig. 5.

Fig. 7 is a graph of the temperature characteristic of resistance of a thin film manufactured by introducing ozone gas besides argon and oxygen gas in the apparatus of Fig. 5.

Fig. 8 is a graph of a composition ratio of Bi/W of a thin film of Embodiment 3 of the present invention.

Fig. 9 is a diagram of X-ray spectra of a thin film of Embodiment 3 of the present invention.

Fig. 10 is a schematic diagram of a structure of layered films of Embodiment 3 of the present invention.

Fig. 11 is a graph of the temperature characteristic of resistance of a thin film of Embodiment 4 of the present invention.

Fig. 12 is a graph of the temperature characteristic of resistance of another thin film of Embodiment 4 of the present invention.

Fig. 13 is a schematic diagram of a section of a thin film obtained in Embodiment 4 of the present invention.

Fig. 14 is a schematic diagram of an apparatus used in Embodiment 5 of the present invention.

Fig. 15 is a graph of the temperature characteristic of resistance of a superconductor thin film obtained in Embodiment 1 of the present invention.

Fig. 16 is a schematic diagram of a section of a thin film obtained in Embodiment 6 of the present invention.

Fig. 17 is a graph of the temperature characteristic of resistance of a thin film obtained in Embodiment 6 of the present invention.

### DETAILED DESCRIPTION OF THE PREFERRED EMBODIMENTS

Referring now to the drawing, embodiments of the present invention will be explained below. First, embodiments with relation to Bi-Ti-O insulator and Bi-Sr-Ca-Cu-O superconductor will be explained.

In order to manufacture a periodic layered structure of Bi system (Bi-Sr-Ca-Cu-O) oxide superconductor thin films and the oxide dielectric films, the inventors first study the interaction between a Bi system superconducting thin film and various kinds of dielectric films.

Usually, a Bi system superconductor thin film is obtained by depositing it on a substrate heated at 600 - 700 °C. Though the as grown thin film is a superconductor, the superconducting characteristics can be improved by heat treatment at 850 - 950 °C.

However, it is found that the superconducting characteristics are deteriorated largely if a dielectric film is layered on the Bi system superconductor thin film due to the mutual diffusion of atoms between the superconductor film and the dielectric film when the substrate temperature is high and if heat treatment is performed after the formation of the dielectric film. In order to prevent the mutual diffusion, the inventors guess that it is necessary that the crystalline properties of the superconductor films and of the dielectric films should be superior, that the lattice matching between the superconductor and dielectric films should be superior and that the dielectric thin film should be stable for the heat treatment at 850 -950 °C.

After various investigations, the inventors find that a thin film of layered structure of bismuth oxides including at least titanium is appropriate as a dielectric film. This is ascribable to the following reasons: The Bi oxides including at least Ti are known to have a layered perovskite structure wherein Bi₂O₂ oxide layers interpose a structure including titanium, oxygen and others, and the Bi₂O₂ layer is very stable under the heat treatment at an interface with a substance of a similar kind of crystal structure. The lattice matching between the Bi system superconductor and the Bi-Ti system oxide is very superior.

As to a thin film of the Bi-Ti-O insulator material, priorly, it is manufactured by depositing Bi-Ti-O particles flying from a substrate by sputtering or ablating a ceramic target with use of a high frequency magnetron sputtering technique or of a laser ablation technique. However, the deposition rate of thin film is as fast as 1 to 10 nm/min in these techniques. Thus, though good crystalline property and dielectric property can be realized for a thin film of thickness of 100 nm or more, a good Bi-Ti-O film of very thin thickness of a few tens nanometer or less cannot be obtained because it is affected directly by the characteristic of the substrate. Then, the inventors prepare a Bi-Ti-O thin film under a slower deposition rate from the start of the deposition in order to investigate a possibility of producing a thin film of better crystalline property.

Bi-Ti-O thin films are manufactured with use of an ion beam sputtering apparatus, and it is found that a very thin film of a few tens nanometers or less depends largely on the behavior of the Bi, Ti and O atoms on the heated substrate. That is, titanium is a material of good oxidizing power, and it is found that not only a titanium metallic element itself but also an oxygen-deficient TiO₂₋ₓ (x>0) becomes TiO₂ if oxygen is available. Further, both Ti and TiO₂ have high melting points of 1600 - 1700 °C, and they do not evaporate again into vacuum from the substrate heated at 600 - 700 °C. On the other hand, bismuth has a low melting point of 270 °C, and it remain as an oxygen-deficient type Bi₂O_{3-y} (y>0) on the heated substrate even if it flies as Bi₂O₃ particles of melting point of 800 °C. If bismuth coexists with titanium, titanium gets oxygen from bismuth and bismuth evaporates again from the substrate. This explains that if a Bi-Ti-O thin film is prepared in such a situation, the surface of Bi-Ti-O thin film located far from the substrate acts as an insulator for a film thickness of 100 nm or more whereas bismuth is extracted from each crystal for a very thin film near the substrate to hinder the action as an insulator. Then, the inventors investigate how to oxidize bismuth stably on the substrate and to coexist bismuth with titanium and checked various kinds of environment on preparing a Bi-Ti-O thin film.

### EMBODIMENT 1

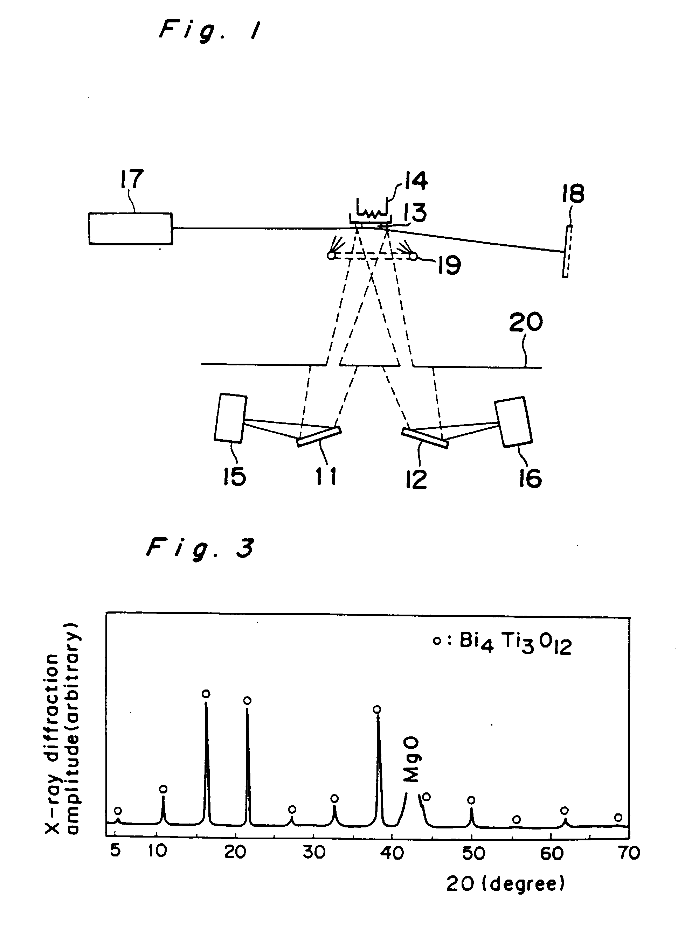

Fig. 1 shows a schematic diagram of a dual ion beam sputtering apparatus used in this experiment, wherein the numeral 11 indicates a Bi₂O₃ target, the numeral 12 indicates a Ti target, the numeral 13 indicates a substrate, the numeral 14 indicates a heater for heating the substrate, the numerals 15 and 16 indicate ion guns, the numeral 17 indicates an electric gun, and the numeral 18 indicates a screen for observing an electron beam diffraction image. The numeral 20 indicates a shutter with an aperture. Further, the numeral 19 indicates a nozzle which supplies gas to the substrate 13. The metallic disc targets 11 and 12 of diameter 60 mm are arranged as shown in Fig. 1.

The substrate 13 is heated by the heater 14, and oxygen and ozone are supplied to the substrate 13 by the nozzle 19. Argon gas is introduced to the ion guns 15 and 16 and the targets 11 and 12 are sputtered with the argon ion beam. The positions of the targets 11, 12 and the ion guns 15, 16 are adjusted so that Bi and Ti particles fly to the MgO (100) substrate 13.

When only oxygen is supplied from the nozzle 19 on forming a Bi-Ti-O film, the adhesion of bismuth to the substrate 13 is very bad, and titanium gets oxygen from bismuth and bismuth evaporates again from the Bi-Ti-O film on the substrate. Therefore, the crystalline property becomes very bad. On the contrary, when ozone gas is added to oxygen gas, the adhesion amount of bismuth increases as explained below.

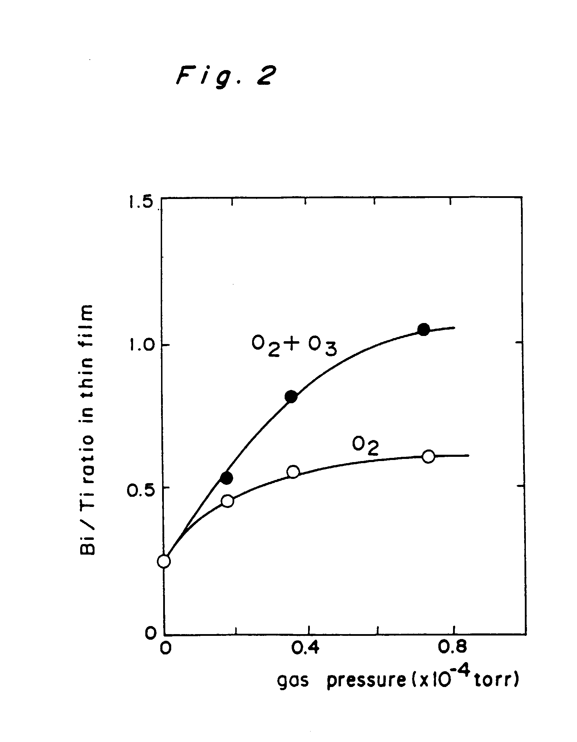

Fig. 2 displays the data of the Bi/Ti ratio in Bi-Ti-O thin films. As is clear from Fig. 2, the adhesion amount of bismuth increases by introducing ozone gas. The film thickness of the Bi-Ti-O thin films is about 20 nm. (The thickness of a unit layer of the crystal structure Bi₄Ti₃O₁₂ is 1.6 nm.) When ozone gas is not introduced, a single phase of crystal structure Bi₄Ti₃O₁₂ which the inventors want to deposit cannot be obtained. However, by introducing ozone gas, a very thin film of thickness about 20 nm can be obtained.

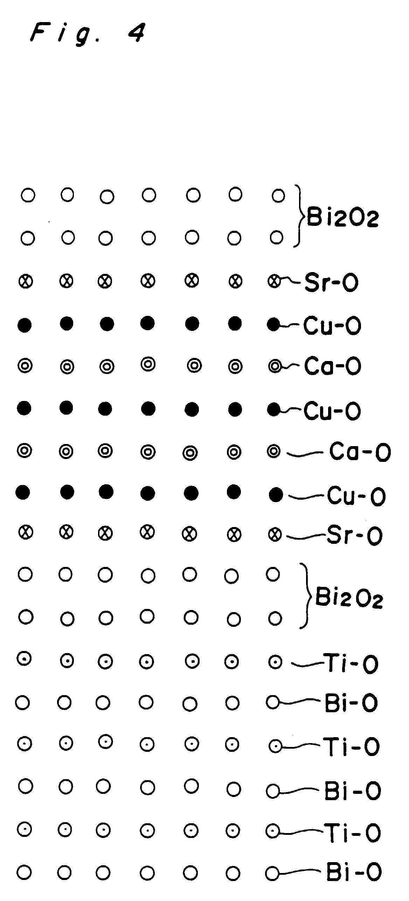

Fig. 3 shows an X-ray diffraction spectra of the Bi-Ti-O thin film, where open circles represent diffraction peaks due to Bi₄Ti₃O₁₂. The Bi-Ti-O aligns along c-axis on the MgO substrate, and the film surface is very flat. This can be interpreted as follows: The oxidation of bismuth flying to the substrate is accelerated by the ozone, and stable Bi-O with no oxygen deficiency reacts efficiently with Ti-O to prepare a Bi₄Ti₃O₁₂ crystal.

The inventors also found that the introduction of activated oxygen gas such as radicals is also effective in order to prepare a Bi-Ti-O thin film similarly beside ozone.

As explained above, in Embodiment 1, a Bi-Ti-O thin film is prepared in an environment including activated oxygen, so that the evaporation of Bi element from a thin film on forming the thin film is suppressed and a Bi-Ti-O thin film of stable crystal phase is obtained. Thus, this manufacturing method of insulator thin film of Embodiment 1 provides an effective manufacturing method of Bi-Ti-O dielectric of a few tens nanometers of film thickness.

Next, a manufacturing method of a layered structure superconductor consisting of Bi-Ti-O thin films and Bi-Sr-Ca-Cu-O superconductor thin films layered periodically in the atomic order with use of the technique of Embodiment 1 is explained. In the method, the resultant superconducting transition temperature of the Bi-Sr-Ca-Cu-O superconductor thin films increases.

Further, when Bi oxides and the oxides of Sr, Ca and Cu are evaporated in vacuum from different evaporation sources to deposit layers periodically in the order of Bi-O, Sr-Cu-O, Ca-Cu-O, Sr-Cu-O and Bi-O, a Bi-Sr-Ca-Cu-O superconductor thin film of very flat film surface of stable film quality can be obtained and it can be layered with the Bi-Ti-O superconductor film effectively by evaporating bismuth oxide and titanium oxide in vacuum from different evaporation sources periodically in the order of Bi-O, Ti-O and Bi-O, under the introduction of activated oxygen gas. The controllability of crystal growth of this process is much better than the manufacturing method of Embodiment 1.

Further, a thin film of periodic structure of m(Bi-Sr-Ca-Cu-O)·n(Bi-Ti-O), wherein m and n are positive integer number which represent the numbers of deposition cycles explained later, can be formed under very good controllability when Bi-O, Sr-Cu-O, Ca-Cu-O and Ti-O are evaporated from different evaporation sources to layer Bi-Sr-Ca-Cu-O superconductor films and Bi-Ti-O dielectric films periodically. The m(Bi-Sr-Ca-Cu-O)·n(Bi-Ti-O) thin films has far better crystalline property and superior superconducting transition temperature and critical current density when compared with a thin film by layering periodically a superconductor thin film by evaporating Bi-Sr-Ca-Cu-O as explained in Embodiment 1 at the same time and an oxide dielectric film obtained by evaporating Bi-Ti-O at the same time. Further, the inventors find that the Bi-Sr-Ca-Cu-O superconductor thin film and the Bi-Ti-O thin film prepared as explained above have very flat film surfaces.

The concept of layering is illustrated by using a schematic diagram shown in Fig. 4, wherein layers around an interface between Bi-Sr-Ca-Cu-O and Bi-Ti-O are displayed. The Ca-O, Cu-O, Sr-O layers in Fig. 4 belong to Bi-Sr-Ca-Cu-O and the Ti-O layer belongs to Bi-Ti-O, while the Bi₂O₂ located at the interface of the two oxides. By layering successively elements composing each layer structure separately, it is considered that the layered deposited atoms move only in a plane in parallel to the substrate surface, while they do not move in a perpendicular direction to the substrate surface. Further, the length of the a-axis of the oxide crystal of the perovskite-like structure including bismuth and titanium is almost equal to that of the Bi-Sr-Ca-Cu-O, so that it is considered that continuous epitaxial crystal growth becomes possible.

Further, the substrate temperature and the heat treatment temperature required to realize better superconducting properties are unexpectedly lower than those of prior methods.

Several methods of periodic layering of Bi-O, Sr-Cu-O, Ca-Cu-O and Ti-O are proposed. In general, periodic layering can be obtained by controlling shutters arranged before the evaporation sources in an molecular beam epitaxy apparatus or in an electron beam evaporation apparatus or by changing the kind of gas in a gas phase growth method. However, sputtering evaporation was thought not appropriate for layering very thin films previously. This is ascribed to the mixing of impurities due to the high gas pressure on forming a film and to damages due to high energy particles. However, the inventors find that a good layered film can be prepared unexpectedly when a thin layer of the Bi oxide superconductor is layered with use of sputtering. It is considered that high oxygen pressure and sputter discharge on sputtering are favorable for preparing the Bi system phase of 100 K or more of critical temperature and the Bi-Ti-O insulator film.

As a technique of layering different materials with sputtering deposition, though a technique of controlling periodically the discharge position of a sputtering target having composition distribution can be used, a technique of sputtering targets of different compositions can attain the object relatively easily. In this case, each sputtering amount of the targets can be controlled or the shutters arranged before the targets can be opened and closed periodically so as to obtain a periodically layered film. Further, the substrate may be moved periodically above each targets. In cases of laser sputtering and ion beam sputtering, if targets are moved periodically to change the target to be illuminated, periodic layering can be conducted. By using such sputtering techniques with use of a plurality of targets, periodic layering of Bi system oxide can be manufactured relatively easily with sputtering of a plurality of targets.

### EMBODIMENT 2

A second embodiment will be explained below concretely.

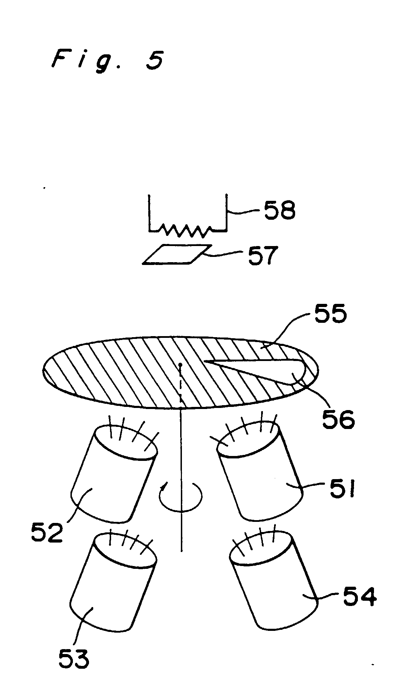

Fig. 5 displays schematically a quadruple magnetron sputtering apparatus used in the present embodiment. In Fig. 5, the numeral 51 indicates a Bi target, the numeral 52 indicates a SrCu alloy target, the numeral 53 indicates a CaCu alloy target, the numeral 54 indicates a Ti target, the numeral 55 indicates a shutter, the numeral 56 indicates a slit, the numeral 57 indicates a substrate, and the numeral 58 indicates a heater for heating the substrate. A nozzle (not shown) is provided near the substrate 57 to supply gas to the substrate 57, as shown in Fig. 1. The total four targets 51, 52, 53 and 54 are arranged as shown in Fig. 5. That is, each target 51, 52, 53, 54 is arranged to be inclined about 30° so as to focus onto the MgO (100) substrate 57. The rotatable shutter 55 is located before the targets, and the rotation of the slit 56 provided in the shutter 55 is controlled by driving the shutter 55 with a pulse motor (not shown), and the cycle and the sputtering time of each target can be set. The substrate 57 is heated with the heater 58 to about 600 °C, and the sputtering of each target is performed in a mixed environment of argon and oxygen (5:1) gases of 3 Pa. Further, as to the oxygen environment, ozone gas is introduced and the ratio of the ozone to oxygen is changed. Experiments are performed by using sputtering currents of each target of Bi: 30 mA, SrCu: 80 mA, CaCu: 300 mA and Ti: 400 mA. The sputtering is conducted in a cycle of Bi → SrCu → CaCu → SrCu → Bi, and the sputtering time of each target is controlled so that the composition ratio of the elements of Bi-Sr-Ca-Cu-O film becomes Bi:Sr:Ca:Cu = 2:2:2:3. By repeating the cycle twenty times, the phase of 100 K or more of superconducting transition temperature can be prepared. Similarly, in a cycle of Bi → Ti → Bi, the sputtering time of each target is controlled so that the composition ratio of the elements of Bi-Ti-O film becomes Bi:Ti = 4:3, and the cycle is repeated four times to decrease the thickness of the Bi-Ti-O film. Then, a Bi-Ti-O film of very good crystalline property can be prepared.

Further, the inventors prepare an m(Bi-Sr-Ca-Cu-O)·n(Bi-Ti-O) film, wherein m and n are positive integer numbers which represent cycles explained later, on the substrate 57 by sputtering each target in a cycle of m × (Bi → SrCu → CaCu → SrCu → Bi) → n × (Bi → Ti → Bi). The inventors investigate the superconducting properties of periodically layered films by changing m under constant n=4.

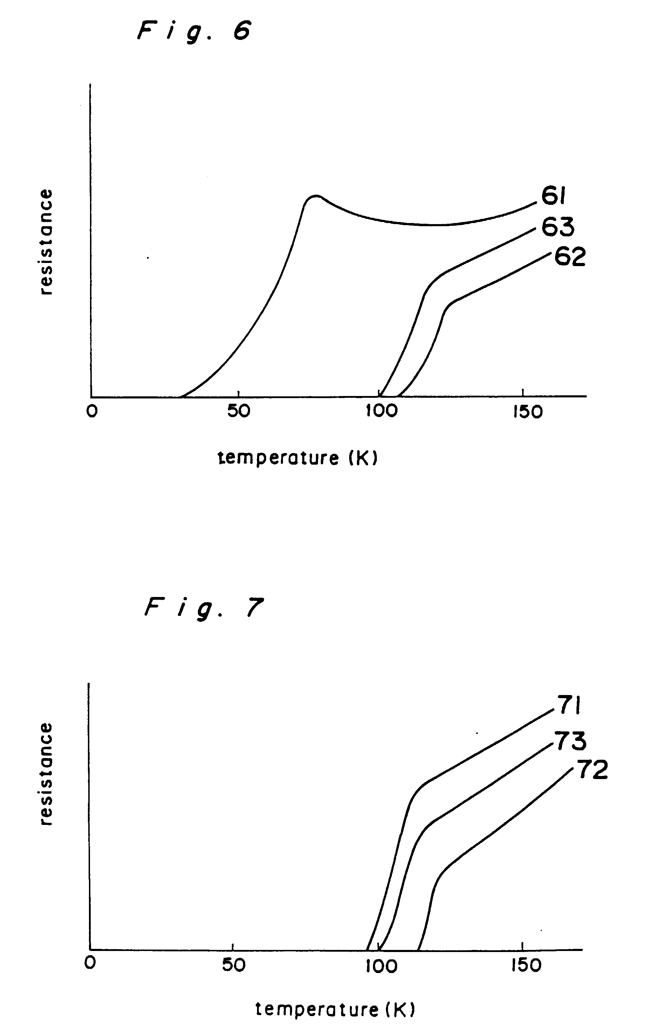

Figs. 6 and 7 show the temperature change of resistance of films of m = 2, 6, 16 as characteristics 61, 62, 63 and 71, 72, 73, respectively, when the supplied gas on sputtering consists only of argon and oxygen and of argon and oxygen and ozone of 4:1. In Fig. 6, the highest superconducting transition temperature and zero resistance temperature, or the characteristic 62 can be realized when m = 6. The superconducting transition temperature and zero resistance temperature of the characteristic 62 are higher by about 8 K when compared with the counterparts of the Bi-Sr-Ca-Cu-O film. Fig. 7 shows similar results. The zero resistance temperature becomes higher in Fig. 7 than in Fig. 6. Though the detailed reasons of this effect is not yet known, it is considered that the periodic layering of the Bi-Sr-Ca-Cu-O film and Bi-Ti-O film causes the epitaxial growth of the Bi-Sr-Ca-Cu-O film and Bi-Ti-O film interposing a Bi₂O₂ layer alternately without the mutual diffusion of atoms at the interface. Further, it is considered that the Bi-Sr-Ca-Cu-O films of superior crystalline property are layered via a Bi-Ti-O thin film of superior crystalline property so that this may affect the superconducting mechanism in the Bi-Sr-Ca-Cu-O film. The introduction of ozone gas is considered to make especially the Bi₂O₂ layer to be manufactured stably between the Bi-Sr-Ca-Cu-O film and the Bi-Ti-O thin film.

The inventors confirm that the superconducting transition temperature is increased effectively in a range of m of 4 to 10 of the Bi → SrCu → CaCu → SrCu → Bi cycle.

When lead (Pb) is added to the target 51 or 54, results similar to the above embodiment can be obtained even if the temperature of the substrate 57 becomes lower by about 100 °C than the counterpart in the above embodiment.

Further, the inventors also confirm that the method of Embodiment 2 is also effective when Bi-Ti-Nb-O, Bi-Ti-Ta-O, Bi-Ti-Ca-O, Bi-Ti-Sr-O, Bi-Ti-Ba-O, Bi-Ti-Na-O and Bi-Ti-K-O is used instead of Bi-Ti-O film.

Further, the inventors also found that the present invention is also effective if activated oxygen such as radicals is used instead of ozone.

Embodiment 2 as well as Embodiment 1 establishes the process at low temperatures which is essential for applications such as a device, and the present invention has a large industrial advantages. The layering of the Bi-system superconductor thin films and insulator films can be obtained reproducibly by layering periodically an oxide including bismuth and an oxide including at least copper and alkaline earth (IIa group) or an oxide including at least titanium in an environment including activated oxygen gas under the control of molecular level, wherein Bi-Sr-Ca-Cu-O thin films and Bi-Ti-O thin films have a structure to have a thermally stable Bi₂O₂ layer interposing the perovskite-like phase layer. Further, the superconducting transition temperature can be increased.

Next, embodiments with relation to Bi-W-O insulator and Bi-Sr-Ca-Cu-O superconductor will be explained.

After various investigations, the inventors find that a thin film of layered structure of bismuth oxides including at least tungsten is appropriate as a dielectric film. This is ascribable to the following reasons similarly to the above-mentioned Bi-Ti-O: The bismuth oxides including at least tungsten are known to have a perovskite structure wherein Bi₂O₂ oxide layer interposes a structure including tungsten, oxygen and others, and the Bi₂O₂ layer is very stable under the heat treatment at high temperatures at an interface with a substance of a similar kind of crystal structure. The lattice matching between the Bi system superconductor and the Bi-Ti oxide is very superior.

The inventors investigate Bi-W-O thin films prepared at a slow deposition rate with use of an ion beam sputtering apparatus. Then, it is found as in the above-mentioned case of Bi-Ti-O that a very thin film of a few tens nanometers or less depends largely on the behavior of the Bi, W and O atoms on the heated substrate. That is, tungsten is a material of good oxidizing power, and it is found that not only a tungsten metallic element itself but also an oxygen-deficient WO₃₋ₓ (x>0) becomes WO₃ if oxygen is available. Further, both W and WO₃ have high melting points of 3382 and 1473 °C, and they do not evaporate again into vacuum from the substrate heated at 600 - 700 °C. On the other hand, Bi has a low melting point of 270 °C, and it remains in an oxygen-deficient type of Bi₂O_{3-y} (y>0) on the heated substrate even if it flies as Bi₂O₃ particles of melting point of 800 °C. If bismuth coexists with tungsten, tungsten gets oxygen from bismuth, which evaporates again from the substrate. This explains that if a Bi-W-O thin film is prepared in such a situation, the surface of Bi-W-O thin film located far from the substrate acts as a dielectric for a film thickness of 100 nm or more whereas Bi is extracted from each crystal for a very thin film near the substrate to hinder the action as a dielectric. Then, the inventors investigate how to oxidize bismuth stably on the substrate and to coexist bismuth with tungsten and checked various kinds of environment on preparing a Bi-W-O thin film.

### EMBODIMENT 3

Bi-W-O thin films are prepared by using the dual ion beam sputtering apparatus shown in Fig. 1 wherein the target 12 is a W target instead of Ti target in Embodiment 1.

When only oxygen is supplied from the nozzle 19 on forming a Bi-W-O film, the adhesion of Bi to the substrate 13 is very bad, and W gets oxygen from Bi and Bi evaporates from the substrate again from the Bi-W-O film. Therefore, the crystalline property becomes very bad. On the contrary, when ozone gas is added to oxygen gas, the adhesion amount of Bi increases.

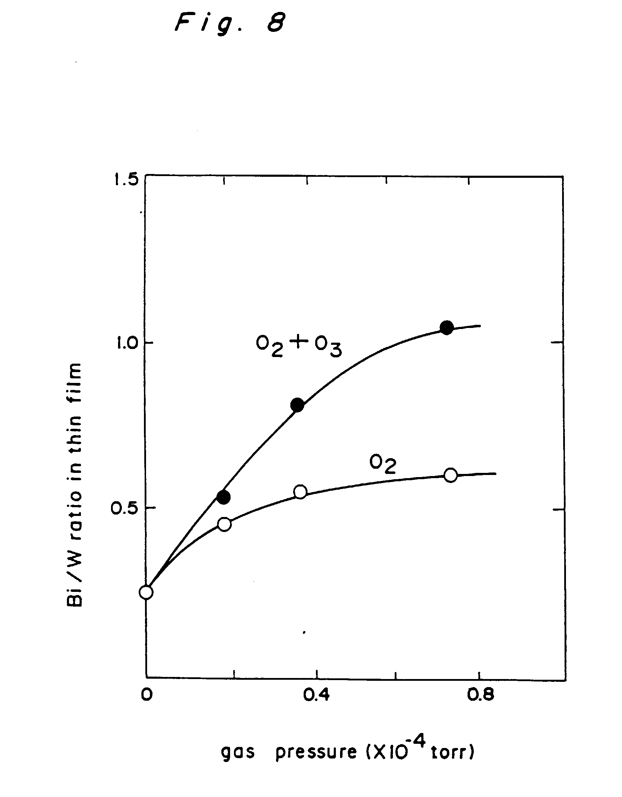

Fig. 8 displays the result of the Bi/W ratio in the Bi-W-O thin film. As is clear from Fig. 8, the adhesion amount of Bi is found to increase by introducing ozone gas. The film thickness of the Bi-W-O thin film is about 20 nm. When ozone gas is not introduced, a single phase of crystal structure Bi₂WO₆ which the inventors want to deposit cannot be obtained. However, by introducing ozone gas, a very thin film of thickness about 20 nm can be obtained.

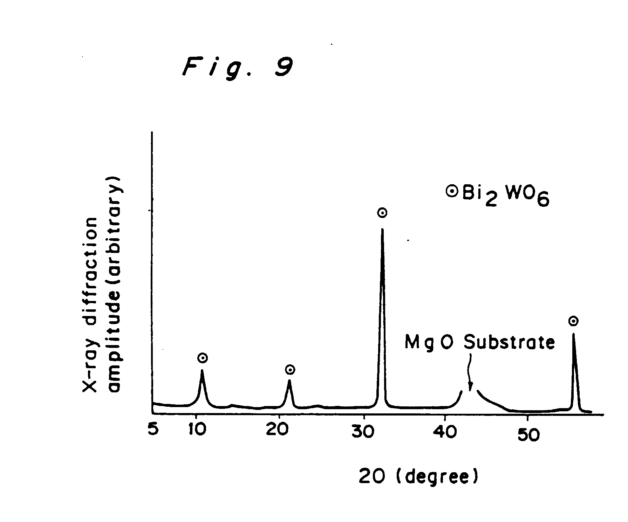

Fig. 9 shows an X-ray diffraction spectra of the Bi-W-O thin film. The Bi-W-O aligns along c-axis on the MgO substrate, and the film surface is very flat. This can be interpreted as follows: The oxidation of bismuth flying to the substrate is accelerated by the ozone, and stable Bi-O with no oxygen deficiency reacts efficiently with W-O to prepare a Bi₂W₁O₆ crystal.

The introduction of activated oxygen gas such as radicals instead of ozone is also effective in order to prepare a Bi-W-O thin film similarly.

It is also confirmed that 300 - 700 °C of the substrate temperature on forming a Bi-W-O thin film is most favorable for realizing better crystalline property.

As explained above, a Bi-W-O thin film is prepared in an environment including activated oxygen, so that the evaporation of Bi element from a thin film on forming the thin film can be suppressed and a Bi-W-O thin film of stable crystal phase. Both bismuth and tungsten can exist as stable oxides. Then, a Bi-W-O insulator substance of for example a few tens nanometers of film thickness can be manufactured.

Next, a manufacturing method of a layered structure superconductor consisting of Bi-W-O thin films and Bi-Sr-Ca-Cu-O superconductor thin films layered periodically in the atomic level with use of the technique of Embodiment 3 is explained. In the method, the resultant superconducting transition temperature of the Bi-Sr-Ca-Cu-O superconductor thin films increases.

In a layered structure, Bi-W-O thin films and Bi-Sr-Ca-Cu-O superconductor thin films are layered periodically in the atomic level with use of the technique of Embodiment 3.

When Bi oxides and the oxides of Sr, Ca and Cu are evaporated in vacuum from different evaporation sources to layer thin films periodically in the order of Bi-O, Sr-Cu-O, Ca-Cu-O, Sr-Cu-O and Bi-O, a Bi-Sr-Ca-Cu-O superconductor thin film of very flat surface of stable film quality can be obtained and it can be layered with the Bi-Ti-O oxide film effectively by evaporating bismuth oxide and tungsten oxide in vacuum from different evaporation sources periodically in the order of Bi-O, W-O and Bi-O and by introducing activated oxygen gas, wherein the controllability of crystal growth is much better than the manufacturing method of Embodiment 3.

Further, a thin film of periodic structure of m(Bi-Sr-Ca-Cu-O)·n(Bi-W-O), wherein m and n represent positive integer number of cycles explained below, can be formed under very good controllability when Bi-O, Sr-Cu-O, Ca-Cu-O and W-O are evaporated from different evaporation sources to layer Bi-Sr-Ca-Cu-O superconductor films and Bi-W-O insulator films periodically. The m(Bi-Sr-Ca-Cu-O)·n(Bi-W-O) thin films has far better crystalline property and superior superconducting transition temperature and critical current density when compared with a thin film by layering periodically a superconductor thin film by evaporating Bi-Sr-Ca-Cu-O at the same time and an oxide insulator film obtained by evaporating Bi-W-O at the same time as Embodiment 3. Further, the Bi-Sr-Ca-Cu-O superconductor thin film and the Bi-W-O thin film prepared as explained above have very flat film surfaces.

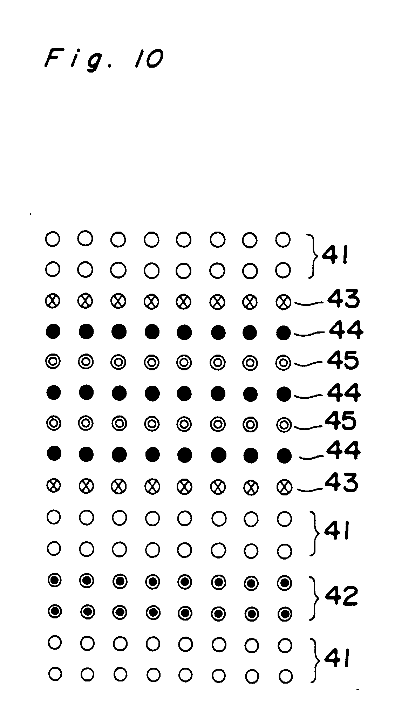

This concept of layering is illustrated by using a schematic diagram shown in Fig. 10, wherein the numeral 41 indicates a Bi₂O₂ layer, the numeral 42 indicates a W-O layer, the numeral 43 indicates a Sr-O layer, the numeral 44 indicates a Cu-O layer, and the numeral 45 indicates a Ca-O layer. That is, by layering successively elements composing each layer structure separately, it is considered that the layered deposited atoms move only in a plane in parallel to the substrate surface, while they do not move in a perpendicular direction to the substrate surface. Further, the length of the a-axis of the oxide crystal of the perovskite structure including bismuth and tungsten is almost equal to that of the Bi-Sr-Ca-Cu-O, so that it is considered that continuous epitaxial crystal growth becomes possible.

Further, the substrate temperature and the heat treatment temperature required to obtain better superconducting properties are unexpectedly lower than those of prior methods.

In order to layer periodically Bi-O, Sr-Cu-O, Ca-Cu-O and W-O, the processes and techniques mentioned above in relation to Embodiment 2 can be used.

### EMBODIMENT 4

A layered structure of superconductor layers and oxide layers is prepared by using a magnetron sputtering apparatus shown in Fig. 5. The target 54 is a W target instead of Ti target in Embodiment 2. The substrate 57 is heated with the heater 58 to about 600 °C, and the sputtering of each target is performed in a mixed environment of argon and oxygen (5:1) gases of 3 Pa. Further, as to the oxygen environment, ozone gas is introduced and the ratio of the ozone to oxygen is changed. Layering is performed by using sputtering currents of each target of Bi: 30 mA, SrCu: 80 mA, CaCu: 300 mA and W: 400 mA.

The sputtering is conducted in a cycle of Bi → SrCu → CaCu → SrCu → Bi, and the sputtering time of each target is controlled so that the composition ratio of the elements of Bi-Sr-Ca-Cu-O film becomes Bi:Sr:Ca:Cu = 2:2:2:3. By repeating the cycle twenty times, the phase of superconducting temperature of 100 K or more can be prepared. Similarly, in a cycle of Bi → W → Bi, the sputtering time of each target is controlled so that the composition ratio of the elements of Bi-W-O film becomes Bi:W = 2:1, and the cycle is repeated four times to decrease the thickness of the Bi-W-O film. Then, a Bi-W-O film of very good crystalline property can be prepared.

Further, an m(Bi-Sr-Ca-Cu-O)·n(Bi-W-O) film, wherein m and n represent positive integer number, is prepared on the substrate 57 by sputtering each target in a cycle of m × (Bi → SrCu → CaCu → SrCu → Bi) → n × (Bi → W → Bi). The superconducting properties of periodically layered films by changing m under constant n=4 are measured.

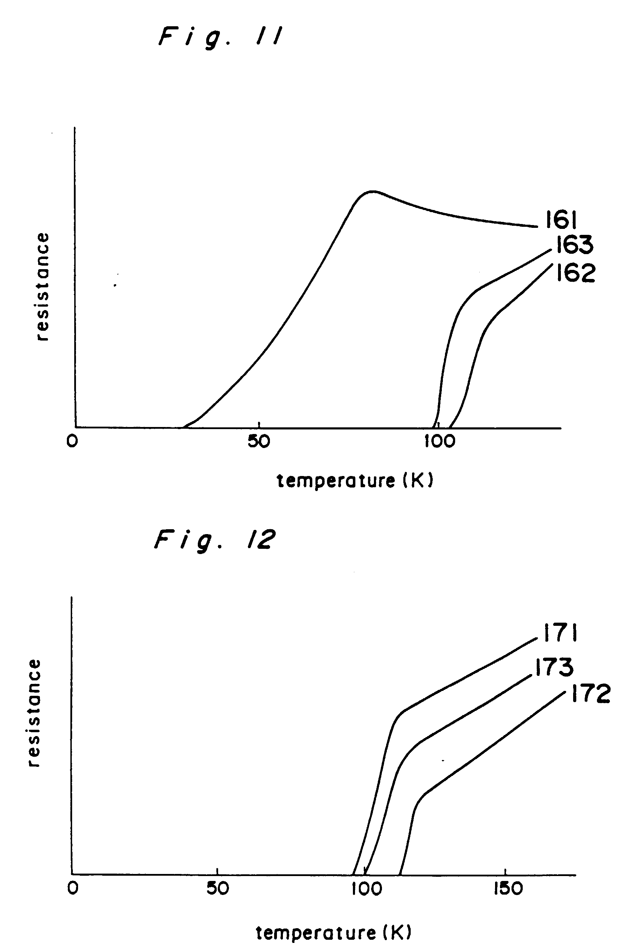

Figs. 11 and 12 show the temperature change of resistance of films of m = 2, 6, 16 as characteristics 161, 162, 163 and 171, 172, 173, respectively, when the supplied gas on sputtering consists only of argon and oxygen and of argon and oxygen and ozone of 4:1. In Fig. 11, the highest superconducting transition temperature and zero resistance temperature, or the characteristic 162 can be realized when m = 6. The superconducting transition temperature and zero resistance temperature of the characteristic 162 are higher by about 8 K when compared with the counterparts of the Bi-Sr-Ca-Cu-O film. Fig. 12 shows similar results except the characteristic 171. The zero resistance temperature becomes higher in Fig. 12 with use of ozone than in Fig. 11.

Though the detailed reasons of this effect is not yet known, it is considered that the periodic layering of the Bi-Sr-Ca-Cu-O film and Bi-W-O film causes the epitaxial growth of the Bi-Sr-Ca-Cu-O film and Bi-W-O film interposing a Bi₂O₂ layer alternately without the effect of the mutual diffusion of atoms at the interface. Further, it is considered that the Bi-Sr-Ca-Cu-O films of superior crystalline property are layered via a Bi-W-O thin film of superior crystalline property so that this may affect the superconducting mechanism in the Bi-Sr-Ca-Cu-O film. Especially, the introduction of ozone gas is considered to make the Bi₂O₂ layer to be manufactured stably between the Bi-Sr-Ca-Cu-O film and the Bi-W-O thin film.

The inventors confirm that the superconducting transition temperature is increased effectively in a range of m of 4 to 10 of the Bi → SrCu → CaCu → SrCu → Bi cycle.

When lead (Pb) is added to the target 51 or 54, the results similar to the above embodiment can be obtained even if the temperature of the substrate 57 becomes lower by about 100 °C than the counterpart in the above embodiment.

Further, activated oxygen such as radicals can also be used effectively instead of ozone.

It is also confirmed that 300 - 700 °C of the substrate temperature on preparing a Bi-W-O thin film is most favorable for realizing better crystalline property.

As explained above, in Embodiment 4, the layering of the Bi-system superconductor thin films and insulator films can be obtained reproducibly by layering periodically an oxide including Bi and an oxide including at least copper and alkaline earth (IIa group) or an oxide including at least tungsten in an environment including activated oxygen gas under the control of molecular level, wherein Bi-Sr-Ca-Cu-O thin films and Bi-W-O thin films have a structure to have a thermally stable Bi₂O₂ layer interposing perovskite-like phase layer. Further, the superconducting transition temperature can be increased. Thus, Embodiment 4 as well as Embodiment 3 establish the process at low temperatures which is essential for applications such as a device.

Next, embodiments with relation to Bi-W-O insulator and Tl-Ba-Ca-Cu-O superconductor will be explained.

Usually, oxide superconductor thin films of Tl-Ba-Ca-Cu-O system or the like are manufactured by depositing it on a substrate heated at 600 °C or lower. After the deposition, the heat treatment at a temperature between 700 and 950 °C is conducted in order to improve the superconducting characteristics.

However, it was found that the superconducting characteristics are deteriorated largely if an insulator film is layered on an oxide superconductor thin film due to the mutual diffusion of atoms between the superconductor film and the insulator film when the substrate temperature is high and or when the heat treatment is performed after the formation of an insulator film. In order to prevent the mutual diffusion, the inventors guess that the crystalline properties of the superconductor films and the dielectric films should be superior, that the lattice matching between the superconductor films and the dielectric films should be superior and that the dielectric thin film should be stable for heat treatment at 700 - 950 °C.

The inventors pay attention to that a Bi-W-O dielectric having a structure interposed between Bi₂O₂ oxide layers is very stable under heat treatment at high temperatures and that the crystal structure of the Bi-W-O dielectric is similar to that of the Tl system superconductor and the lattice constant of the Bi-W-O dielectric is near that of the Tl system superconductor. Further, the inventors also take notice of that the crystal structure of Bi-W-O dielectric consists of simple layering of Bi-O layers and W-O layers.

### EMBODIMENT 5

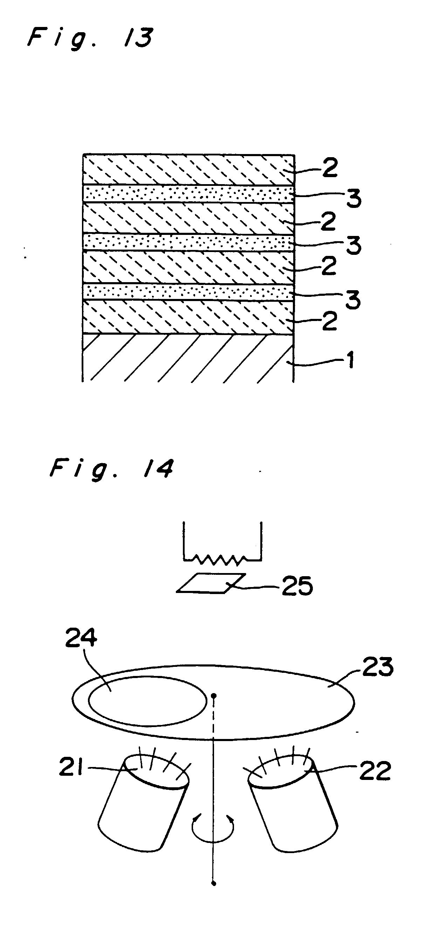

Fig. 13 shows schematically a section of a thin film manufactured in this embodiment. That is, Tl-Ba-Ca-Cu-O films 2 and Bi-W-O films 3 are layered on a substrate 1.

Fig. 14 displays a schematic diagram of a thin film manufacturing apparatus used in this experiment. In order to layer such oxide thin films, Tl-Ba-Ca-Cu-O films are deposited with a high frequency magnetron sputtering of dual sputtering targets of a Tl₃Ba₂Ca₂Cu₂Oₓ disk target 21 of mixed oxide annealed at 850 °C for five hours in air and a Bi₂WO_{y} disk target 22. The numeral 23 indicates a shutter, the numeral 24 indicates a slit, while the numeral 25 indicates a substrate. A nozzle (not shown) is provided near the substrate 25 to supply gas to the substrate 25, as shown in Fig. 1. The targets are inclined by about 30° so as to focus on the MgO (100) substrate 25. The rotatable shutter 23 is arranged before the targets, and the rotation of the slit 24 provided in the shutter 25 is controlled by driving the shutter 23 with a pulse motor. Thus, Tl-Ba-Ca-Cu-O thin films 2 and Bi-W-O thin films 3 can be deposited alternately on the substrate 25. Mixed gas of Ar and O₂ (Ar:O₂ = 1:9, 0.6 Pa) is used as a sputtering gas. By supplying 80 W and 60 W of sputter power to the targets 21 and 22, the targets are sputtered and Tl-Ba-Ca-Cu-O thin films and Bi-W-O thin films are deposited on the substrate 25 heated at 500 °C. The deposition is started from a Tl-Ba-Ca-Cu-O thin film. The thickness of Tl-Ba-Ca-Cu-O thin film is made constant to be 50 nm and the thickness of Bi-W-O system is changed, and the deposition is conducted for four periods. After the deposition, heat treatment is performed at 900 °C for ten minutes in an oxygen environment.

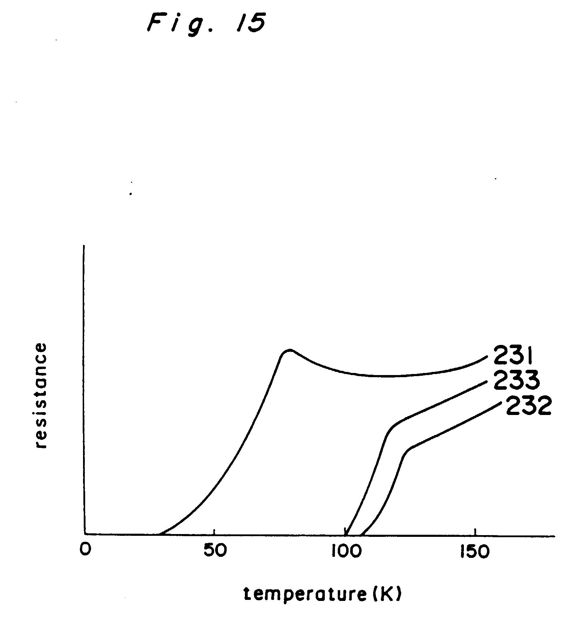

Fig. 15 shows the temperature characteristic of resistance of superconductor film plotted against a change in film thickness of Bi-W-O thin films per period. In Fig. 15, the numerals 231, 232, 233 indicate the results when the thickness of the Bi-W-O thin film layer are 30, 15 and 5 nm, respectively. The highest superconducting transition temperature and zero resistance temperature, or the characteristic 32 is realized when the thickness of Bi-W-O thin film layer is 15 nm. The superconducting transition temperature and zero resistance temperature of the characteristic 32 are higher by about 8 K when compared with the counterparts of the Tl-Ba-Ca-Cu-O film itself.

Though the detailed reasons of this effect is not yet known, it is considered that the periodic layering of the Tl-Ba-Ca-Cu-O film and Bi-W-O film causes the epitaxial growth of the Tl-Ba-Ca-Cu-O film and Bi-W-O film interposing a Bi₂O₂ layer alternately which does not affect the mutual diffusion of elements at the interface and has superior crystalline property. Further, it is considered that the Tl-Ba-Ca-Cu-O films of superior crystalline property and of good lattice matching with the Bi-W-O layer are layered via a Bi-W-O thin film of superior crystalline property so that this may affect the superconducting mechanism in the Tl-Ba-Ca-Cu-O film.

Further, it is found that if the substrate 25 heated at a high temperature, Tl is not included in a thin film because Tl evaporates again from the thin film due to anomalously high vapor pressure of Tl. On the other hand, it is necessary to conduct heat treatment after the deposition in order to improve the crystalline property of Tl-Ba-Ca-Cu-O. In order to prevent mutual diffusion of atoms between Tl-Ba-Ca-Cu-O layers and Bi-W-O layers, it is needed that the Bi-W-O thin films consist of Bi₂WO₆ crystal when the thin film is deposited. Then, the relation between the temperature of the substrate 25 and the crystalline property of thin film is investigated, and it is found that the temperature of the substrate 25 is preferably between 300 and 600 °C.

Thus, it is found that the Bi-W-O is superior as an insulator to be arranged between oxide superconductors. This is ascribable to the following facts. The material has a layered perovskite crystal structure wherein Bi₂O₂ layers interpose a structure consisting of tungsten and oxygen, and the Bi₂O₂ layers is very stable at high temperature heat treatment at an interface with a material of crystal structure of similar kinds. Because the lengths of the a and b axes of the Bi₂O₂ layer are almost equal to the counterparts of Tl-Ba-Ca-Cu-O oxide superconductor, the Bi₂O₂ layer has very superior crystal matching. Thus, when a thin film of this material is prepared, continuous epitaxial crystal growth of Bi-W-O on Ti-Ba-Ca-Cu-O oxide superconductor and of Tl-Ba-Ca-Cu-O oxide superconductor on Bi-W-O becomes possible. If Tl-Ba-Ca-Cu-O oxide superconductor is applied to an electronic device, the thickness of the Bi-W-O insulator layer demanded to be of the order of a few tens nanometers can be realized. Further, it is confirmed that the crystal structure of the Tl-Ba-Ca-Cu-O superconductor consists of Tl-O, Ba-Cu-O and Ca-Cu-O layers layered successively, while that of Bi-W-O consists of Bi-O and W-O layers layered successively.

According to Embodiment 5, the Tl system superconductor thin film of a crystal structure, covered by a Tl₂O₂ oxide layer or a layer including it as a main body, and a Bi-W-O insulator thin film of a crystal structure, covered by a thermally stable Bi₂O₂ oxide film layer or a layer including it as a main body which has the same lattice-constant as that of the Tl system superconductor crystal, are layered alternately. This structure makes it possible to layer them without mutual diffusion between the superconductor thin film and the insulator thin films. Thus, the superconducting transition temperature of the Tl system superconductor thin film becomes stable and reproducible.

### EMBODIMENT 6

Next, a modified method of manufacturing a layered structure superconductor is explained. It is prepared by using a sputtering apparatus shown in Fig. 5. The target 51 is a Tl metallic disc target, the target 52 is a Ba-Ca-Cu-O centered disc target of element ratio Ba:Ca:Cu=2:2:3, the target 53 is a Bi metallic disc target, and the target 54 is a W metallic disc target. Sputtering deposition is conducted in a cycle of (Tl → Ba-Ca-Cu-O → Tl) and in a cycle of (Bi → W → Bi).

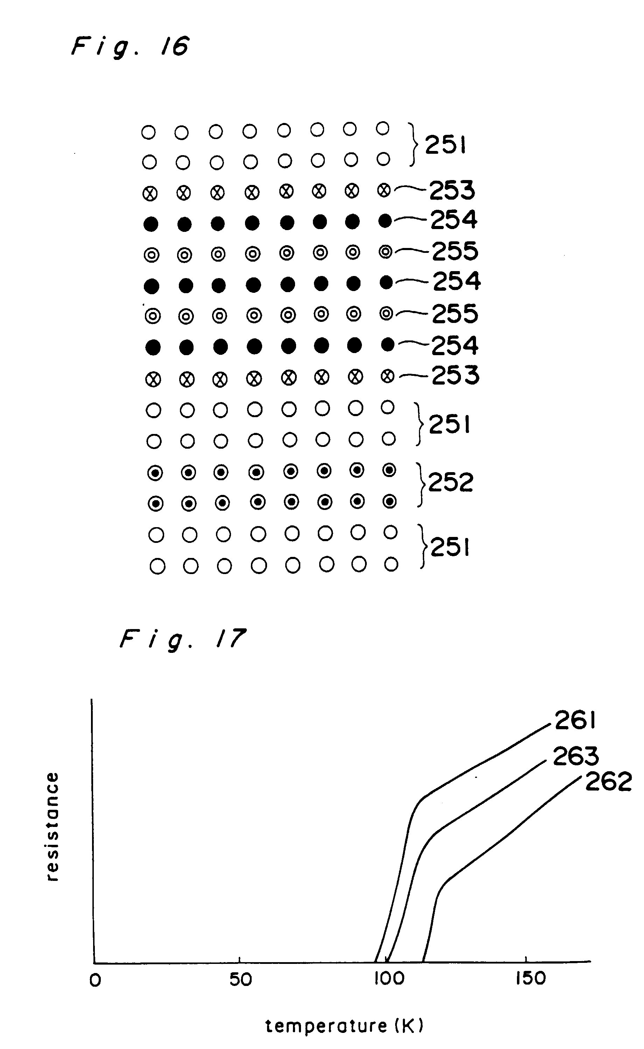

Fig. 16 shows schematically the layering for a layered structure. In Fig. 16, the numeral 251 indicates Tl₂O₂ layer, the numeral 252 indicates a W-O layer, the numeral 253 indicates a Ba-O layer, the numeral 254 indicates a Cu-O layer and the numeral 255 indicates a Ca-O layer. By controlling the input powers to the targets 51, 52, 53 and 54 and the sputtering time of each target, the thicknesses of the Tl-Ba-Ca-Cu-O layers 2 and the Bi-W-O layers 3 deposited on the substrate 57 can be changed. The substrate 57 is heated to about 500 °C, and the sputtering of each target is performed in a mixed environment of argon and oxygen (1:1) of 0.5 Pa. After the deposition, heat treatment at 900 °C is conducted for ten minutes in an oxygen environment.

The sputtering time and the sputtering current are controlled so that the composition ratio of the elements of Tl-Ba-Ca-Cu-O film becomes Tl:Ba:Ca:Cu = 2:2:2:3 and that of Bi-W-O film becomes Bi:W = 2:1. In this case, the lower limit of film thickness is considered to be several nanometers as far as the crystalline property is maintained. Because it is desirable that the film thickness of insulator film is as thin as possible, a period expressed as k·(Tl → Ba-Ca-Cu-O → Tl) → l·(Bi →W → Bi) is repeated twenty times. The thickness of Bi-W-O film which can be prepared without losing good crystalline property is limited at k=2.

Then, the temperature change in the resistivity of thin film of k=2 is investigated by changing the repetition number l. Fig. 17 shows the results. In Fig. 17, the numerals 261, 262 and 263 indicate the result of 1=2, 1=6 and 1=10, respectively. As is clear from Fig. 17, the superconducting transition temperature and zero resistance temperature increase most, when compared with a sample without layering insulator films Bi-W-O. A physical reason is considered to be ascribed to good controllability of the layering of both Tl-Ba-Ca-Cu-O thin films and Bi-W-O thin films according to Embodiment 6.

Further, a thin film can also be prepared by evaporating Tl oxide and oxides of Ba, Ca, Cu, Bi and W from different evaporation sources separately and by layering a similar structure periodically, instead of sputtering technique, under good controllability as the above-mentioned method and the obtained thin film has stable film property. There are other methods of layering Tl-O, Ba-Ca-Cu-O, Bi-O and W-O. For example, in general, periodic layering can be conducted in a molecular beam epitaxial apparatus or in an electron beam evaporation apparatus by controlling a shutter located before evaporation sources or in a gas phase growth method by changing the kind of gas.

It was considered that sputtering evaporation is not appropriate for layering a very thin layer of this kind. This was ascribed to the mixing of impurities due to high gas pressure and to damages due to high energy particles.

However, a good layered film can be prepared unexpectedly when a thin layer of the Bi oxide superconductor is layered with use of sputtering. It is considered that high oxygen pressure and sputter discharge on sputtering are favorable for preparing the Tl system phase of critical temperature of 100 K or more and the Bi-W-O dielectric film.

As explained above, a thin film of periodic structure of m(Tl-Ba-Ca-Cu-O)·n(Bi-W-O), wherein m and n are positive integer numbers of the cycles, can be formed under very good controllability when Tl-O, Ba-Ca-Cu-O and Bi-O are evaporated from different evaporation sources to layer Tl-Ba-Ca-Cu-O superconductor films and Bi-W-O insulator films periodically. A thin film can also be manufactured easily by using complex oxides Tl-Ba-Ca-Cu-O and Bi-W-O as evaporation sources. By using different evaporation sources, the crystalline property becomes better and the controllability of the composition is improved. Further, it is also found that the m(Tl-Ba-Ca-Cu-O)·n(Bi-W-O) thin films has far better superconducting transition temperature and critical current density. Further, the Tl-Ba-Ca-Cu-O superconductor thin film and the Bi-W-O thin film prepared as explained above have very flat film surfaces. On layering successively elements composing each layer structure separately, it is considered that the layered deposited elements move only in a plane in parallel to the substrate surface, while they do not move in a perpendicular direction to the substrate surface. Further, the length of the a-axis of the oxide crystal of the perovskite layer structure including Bi and W is almost equal to that of the Tl-Ba-Ca-Cu-O, so that it is considered that continuous epitaxial crystal growth becomes possible.

Further, the substrate temperature and the heat treatment temperature required to obtain better superconducting properties are unexpectedly lower than those of prior methods.

In Embodiment 6, in order to manufacture a layered superconductor structure very stably in a microscopic scale, an oxide thin film is formed by layering periodically an oxide including at least thallium, an oxide including at least copper and alkaline earth (IIa group), an oxide including at least bismuth and an oxide including at least tungsten are layered periodically, under the control of atomic level. Thus, the layering of Tl system superconductor thin films and insulator thin films can be realized reproducibly.

## Claims

1. A manufacturing method of an oxide thin film, comprising the steps of:
providing a substrate (1);
heating the substrate (1),
supplying an environment including activated oxygen gas around the substrate (1);
characterized by the steps of
depositing an oxide superconductor layer (2) including at least thallium, copper and an alkaline earth element in the IIa group in the periodic table; and
depositing an oxide insulator layer (3) including at least bismuth, tungsten and oxygen as main components on the superconductor oxide layer;
wherein the successive deposition of an oxide superconductor layer (2) and oxide insulator layer (3) is repeated at least once.

2. A manufacturing method according to Claim 1, wherein said oxide superconductor layer (2) is a Tl-Ba-Ca-Cu-O layer.

3. A manufacturing method according to Claim 1, wherein the deposition is conducted with sputtering.

4. A manufacturing method according to Claim 1, wherein said depositing step of an oxide insulator comprising the steps of:
depositing a first layer of an oxide including at least bismuth;
depositing a second layer of an oxide including at least tungsten on the first layer; and
depositing a third layer of the oxide including at least bismuth on the second layer;
wherein the successive deposition of the second layer and third layer are conducted at least once.

5. A manufacturing method according to Claim 1, wherein said depositing step of an oxide superconductor comprising the steps of:
depositing a first layer of a first oxide including at least thallium;
depositing a second layer of an oxide including at least the alkaline earth and copper on the first layer;
depositing a third layer of the oxide including at least thallium;
wherein the successive deposition of the first to third layers are repeated at least once.

6. A manufacturing method of superconductor thin film according to Claim 1, wherein the temperature of the substrate (1) is set to be below 600 °C.

7. A manufacturing method according to Claim 1, further comprising the step of heat treatment which is conducted in an environment including at least oxygen after the thin film is manufactured.

## Patentansprüche

1. Herstellungsverfahren für eine dünne Oxidschicht, mit den Schritten:
ein Substrat (1) wird zur Verfügung gestellt;
das Substrat (1) wird aufgeheizt;
äußere Bedingungen werden bereitgestellt, einschließlich einem aktivierten, das Substrat (1) umgebende Sauerstoffgas;
durch die Schritte gekennzeichnet, daß
eine Supraleiter-Oxidschicht (2), die mindestens Thallium, Kupfer und ein alkalisches Erdelement der lla-Gruppe des Periodensystems enthält, abgeschieden wird; und
eine Isolations-Oxidschicht (3), die mindestens Wismut, Wolfram und Sauerstoff als Hauptkomponenten enthält, auf der Supraleiter-Oxidschicht abgeschieden wird;
wobei die aufeinanderfolgende Abscheidung einer Supraleiter-Oxidschicht (2) und einer Isolations-Oxidschicht (3) mindestens einmal wiederholt wird.

2. Herstellungsverfahren nach Anspruch 1,
dadurch gekennzeichnet, daß die Supraleiter-Oxidschicht (2) eine Tl-Ba-Ca-Cu-O-Schicht ist.

3. Herstellungsverfahren nach Anspruch 1,
dadurch gekennzeichnet, daß die Abscheidung durch Sputtern ausgeführt wird.

4. Herstellungsverfahren nach Anspruch 1,
dadurch gekennzeichnet, daß der Schritt der Abscheidung eines Oxid-Isolators die Schritte beinhaltet:
eine erste Schicht eines Oxids, mindestens Wismut enthaltend, wird abgeschieden;
eine zweite Schicht eines Oxids, mindestens Wolfram enthaltend, wird auf der ersten Schicht abgeschieden; und
eine dritte Schicht des Oxids, mindestens Wismut enthaltend, wird auf der zweiten Schicht abgeschieden;
wobei die aufeinanderfolgende Abscheidung der zweiten Schicht und der dritten Schicht mindestens einmal durchgeführt wird.

5. Herstellungsverfahren nach Anspruch 1,
dadurch gekennzeichnet, daß der Schritt der Abscheidung eines Oxid-Supraleiters die Schritte enthält:
eine erste Schicht eines ersten Oxids, mindestens Thallium enthaltend, wird abgeschieden;
eine zweite Schicht eines Oxids, mindestens eine alkalische Erde und Kupfer enthaltend, wird auf der ersten Schicht abgeschieden;
eine dritte Schicht des Oxids, mindestens Thallium enthaltend, wird abgeschieden;
wobei die aufeinanderfolgende Abscheidung der ersten bis dritten Schichten mindestens einmal wiederholt wird.

6. Herstellungsverfahren eines Dünnschichtsupraleiters nach Anspruch 1, dadurch gekennzeichnet, daß die Temperatur des Substrats (1) unterhalb von 600° C eingestellt wird.

7. Herstellungsverfahren nach Anspruch 1,
gekennzeichnet durch einen Hitzebehandlungsschritt, welcher nach der Herstellung der dünnen Schicht in einer Umgebung ausgeführt wird, die mindestens Sauerstoff enthält.

## Revendications

1. Procédé de fabrication de film mince d'oxyde, comportant les étapes de:
préparation d'un substrat (1) ;
chauffage du substrat (1) ;
établissement d'un environnement comportant du gaz d'oxygène activé autour du substrat (1) ;
*caractérisé par les étapes de :*
dépôt d'une couche supraconductrice d'oxyde (2) comportant au moins du thallium, du cuivre et un élément alcalino-terreux du groupe IIA du tableau périodique des éléments ; et
dépôt d'une couche isolante d'oxyde (3) comportant au moins du bismuth, du tungstène et de l'oxygène comme éléments principaux sur la couche d'oxyde supraconductrice ;
dans lequel le dépôt successif d'une couche supraconductrice d'oxyde (2) et d'une couche isolante d'oxyde (3) est répété au moins une fois.

2. Procédé de fabrication selon la revendication 1, dans lequel ladite couche supraconductrice d'oxyde (2) est une couche de Tl-Ba-Ca-Cu-O.

3. Procédé de fabrication selon la revendication 1, dans lequel le dépôt est réalisé par pulvérisation.

4. Procédé de fabrication selon la revendication 1, dans lequel ladite étape de dépôt d'un isolant d'oxyde comporte les étapes de :
dépôt d'une première couche d'un oxyde comportant au moins du bismuth ;
dépôt d'une seconde couche d'un oxyde comportant au moins du tungstène sur la première couche ; et
dépôt d'une troisième couche de l'oxyde comportant au moins du bismuth sur la seconde couche ;
dans lequel le dépôt successif de la seconde couche et de la troisième couche est réalisé au moins une fois.

5. Procédé de fabrication selon la revendication 1, dans lequel ladite étape de dépôt d'un supraconducteur d'oxyde comporte les étapes de :
dépôt d'une première couche d'un premier oxyde comportant au moins du thallium ;
dépôt d'une seconde couche d'un oxyde comportant au moins l'élément alcalino-terreux et le cuivre sur la première couche ;
dépôt d'une troisième couche de l'oxyde comportant au moins le thallium ;
dans lequel le dépôt successif des première aux troisième couches est répété au moins une fois.

6. Procédé de fabrication d'un film mince supraconducteur selon la revendication 1, dans lequel la température du substrat (1) est ajustée pour être au dessous de 600°c.

7. Procédé de fabrication selon la revendication 1, comportant en outre l'étape de traitement par la chaleur qui est réalisée dans un environnement comportant au moins de l'oxygène après que le film mince ait été fabriqué.
